Europäisches Patentamt

(19) European Patent Office

Office européen des brevets

(11) Publication number: **0 019 941**
**B1**

(12) **EUROPEAN PATENT SPECIFICATION**

(45) Date of publication of patent specification: **02.10.85**

(21) Application number: **80103125.3**

(22) Date of filing: **04.06.80**

(51) Int. Cl.⁴: **G 03 B 41/00,** G 05 D 3/00,
G 01 B 11/27

(54) Reduction projection aligner system.

(30) Priority: **04.06.79 JP 68971/79**

(43) Date of publication of application:
**10.12.80 Bulletin 80/25**

(45) Publication of the grant of the patent:
**02.10.85 Bulletin 85/40**

(84) Designated Contracting States:
**DE FR GB NL**

(56) References cited:
FR-A-2 296 215
US-A-3 796 497
US-A-3 943 359

IBM TECHNICAL DISCLOSURE BULLETIN, vol.
9, October 1966, NEW YORK (US), H.R.
ROTTMAN: "Position Detecting apparatus",
pages 540-541

The file contains technical information
submitted after the application was filed and
not included in this specification

(73) Proprietor: **Hitachi, Ltd.**
**5-1, Marunouchi 1-chome**
**Chiyoda-ku Tokyo 100 (JP)**

(72) Inventor: **Kuniyoshi, Shinji**
**2-11-7, Hounan Suginami-ku**
**Tokyo (JP)**
Inventor: **Takanashi, Akihiro**
**1-28-32, Fujimoto Kokubunji-shi**
**Tokyo (JP)**
Inventor: **Kurosaki, Toshiei**
**3-1-3, Higashi-koigakubo Kokubunji-shi**
**Tokyo (JP)**

(74) Representative: **Strehl, Peter, Dipl.-Ing. et al**
**Strehl, Schübel-Hopf, Schulz Patentanwälte**
**Widenmayerstrasse 17 Postfach 22 03 45**
**D-8000 München 22 (DE)**

## Description

This invention relates to improvements in a reduction projection aligner system for use in semiconductor production.

The reduction projection aligner system is used for semiconductor production, and forms patterns of semiconductor integrated circuits such as ICs and LSIs directly on wafers. In many conventional reduction projection aligner systems, the wafer and a reticle (a glass plate on which an original pattern is depicted) have been positioned independently of each other.

US—A—41 53 371 discloses a reduction projection aligner system in which the reticle is positioned by visually detecting a positioning pattern on the reticle and brought in a predetermined position in relation to a mechanical origin on the body of the apparatus by aligning the positioning pattern on the reticle in relation to fixed sensors. The distance between the projections of a positioning pattern on the wafer and a corresponding pattern provided on the reticle is measured, and the measured information is used to drive the reticle to a new position in relation to the mechanical origin. In such system, however, the projection of the position pattern of the wafer on the reticle is to be viewed by the eye which may be the cause of defaults.

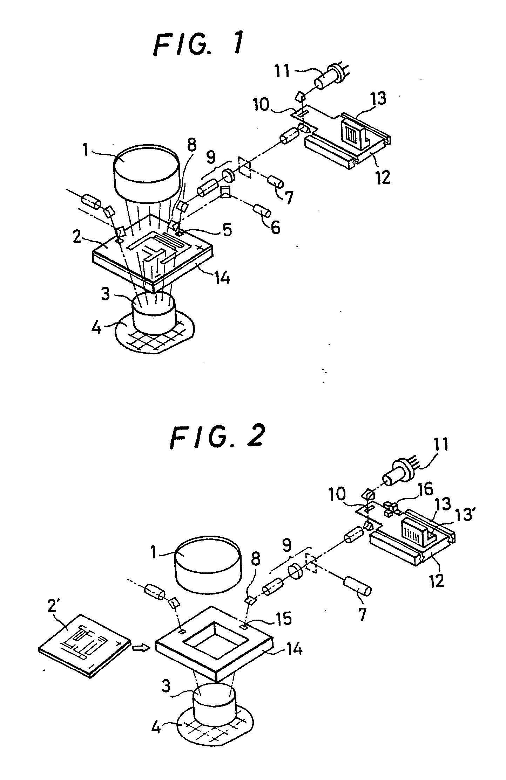

There has been devised a method as shown in Figure 1 wherein the position of a wafer is detected through a reticle as well as a reduction lens.

In the reduction projection aligner system shown in Figure 1, a pattern for positioning formed on a wafer 4 by a preceding step is illuminated by a light guide 7 through a reference pattern 5 formed on an edge of a reticle 2 and further through a reduction lens 3, and using the reflected light, the positioning pattern on the wafer is focused on the reticle 2 contrariwise. On the other hand, in order to detect the position of the reticle 2, the reference pattern 5 on the reticle 2 is illuminated by a light guide 6. Thus, the reflected lights from the wafer 4 and the reticle 2 are projected on the path of movement of a slit 10 by a magnifying optical system 9, the distance of movement of the slit 10 is measured by a uniaxial movable table 12 and a measuring machine 13, and an output from a photodetector 11 corresponding to the position of the slit 10 is detected, whereby the relative positions of the reticle 2 and the wafer 4 are detected.

With this system, however, the predetermined reference pattern 5 needs to be formed in a specified position on the reticle 2 separately from a circuit pattern and a reticle positioning pattern (which is used for positioning the reticle 2 to a holder 14), and it forms a serious hindrance in preparing the reticle. Moreover, the arrangement error of the reference pattern 5 with respect to the circuit pattern becomes the alignment error between the reticle 2 and the wafer 4. Further, since the relative positions of the reticle 2 and the wafer 4 are detected, an optical system for illuminating the reticle surface consisting of the light guide 6 and a mirror 8 needs to be installed, and this installation is very difficult. In the figure, numeral 1 designates a condensing lens.

This invention has for its object to provide a reduction projection aligner system in which a positioning pattern on a wafer obtained through a reduction lens is detected by the use of a detecting optical system of installation, permitting a high precision detection of the wafer position relative to the body of the system.

In order to accomplish the object, according to this invention, a reduction projection aligner system wherein a pattern provided on a reticle is formed directly on a wafer by reducing and projecting the pattern onto the wafer through a reduction projection lens, and which comprises means to optically magnify and project and then focus a positioning pattern provided on said wafer onto a focal plane through said lens, means to scan the focal plane with a slit, and means to relatively move and position the reticle so as to cause the position of its projected image to coincide with the position of said wafer, further comprises an origin sensor provided with a mechanical origin on a body of said system for determining a reference position of said slit, means to measure the distance from said reference position to a position where the slit is aligned with the projected positioning pattern to thereby determine the position of said wafer relative to the body of said system, and by said means to relatively move and position the reticle being controlled on the basis of the measurement by said distance measuring means.

Figure 1 is a view for explaining a reduction projection aligner system already proposed,

Figure 2 is a view for explaining an embodiment of this invention,

Figure 3 is a view showing the details of a pattern detecting portion,

Figure 4 is a view showing an example of a positioning pattern on a wafer projected on a slit, and

Figure 5 is a graph showing examples of signals stored in a central processing unit.

Hereunder, this invention will be described in detail with reference to embodiments.

A conceptual diagram of a reduction projection aligner system according to this invention is shown in Figure 2. The system of this invention greatly differs from the system shown in Figure 1 in the following points. A part of the holder 14 for a reticle 2' is provided with a hole 15 to allow illumination of a pattern on wafer 4 via the light guide 7 and the reduction projection lens 3 as in the system shown in Figure 1. The reticle 2' to be placed on the holder 14 does not need to be provided with the special reference mark 5 as shown in Figure 1, and it may merely have a structure adapted to transmit light through the edge thereof. Further, the light guide 6 for illuminating the reference mark 5 is unnecessary, and one mirror 8 suffices. In addition, the position pattern (for example, a rectilinear mark usually having a width of 6 µm or so) on the wafer as focused on the reticle is projected on the path of movement of the slit 10 through the optical system 9. An origin sensor 16 is disposed within the range of movement of the member in which slit 10 is formed, and the distance from the origin of the slit 10 to its position when aligned with the image of the positioning pattern of the wafer is measured by the measuring machine 13. The origin sensor 16 is fixed on the body of the system, so that the distance of movement of the slit to its position when aligned with the image of the positioning pattern on the wafer after the slit has passed through the origin is gauged as a measure of the position of the wafer relative to the body of the system.

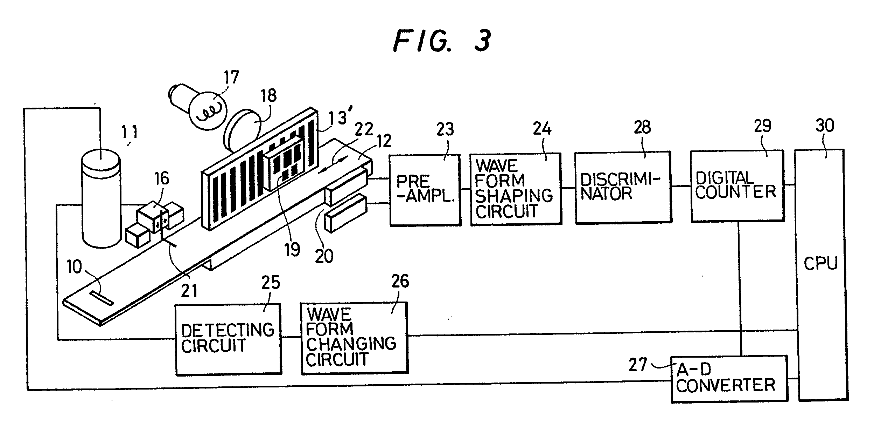

The details of a pattern detecting portion are shown in Figure 3. On the unaxially movable table 12, there are placed the slit 10, a member to-be-detected 21 for the origin sensor 16, and a glass scale 13'. The glass scale 13' is movable only in the direction of arrow 22 with uniaxially movable table 12. An index scale 19 is fixed at a predetermined spacing with respect to the glass scale 13'. The glass scale 13' and the index scale 19 are provided with grating lines at equal spacings, and they are sandwiched in between a light source 17 with a lens 18 and a photodetector 20. Light projected from the light source 17 on to the photodetector 20 changes from high to zero intensity each time the grating of the glass scale 13' moves one pitch with respect to the index scale 19, and the photodetector output is a sinusoidal signal. Since the output signal from the photodetector 20 is feeble as it is, it is amplified by a pre-amplifier 23. Further, the amplified signal is passed through a waveform shaping circuit 24 and a direction discriminator 28 and is indicated as a digital quantity by a digital counter 29. This digital quantity means the distance of movement of the slit. On the other hand, as the origin sensor 16, there is employed by way of example a magnetic transducer which uses the principle of magnetic recording. When the magnetic conductor 21 which is the member to-be-detected placed on the movable table 12 moves in the sense of the arrow 22, an analog output of, for example, about 1 mV/µm is produced via the magnetic transducer 16 and a detecting circuit 25, and it is turned into a pulse output by a waveform changing circuit 26. Herein, the system is operated under the condition that the spacing between the magnetic transducer 16 and the magnetic conductor 21 is set at, for example, below 0.5 mm. When the magnetic conductor 21 placed on the movable table 12 passes in front of the magnetic transducer 16, the pulse output is obtained at a reproduction precision of approximately 1 µm.

On the other hand, the intensity of light passed through the slit is photoelectrically converted by the photomultiplier 11, the output of which is applied to an analog-to-digital converter 27. The A—D converter 27 digitizes the photomultiplier output in synchronism with the counter output from the digital counter 29, which means the position of the slit and applies the digital signal to a central processing unit 30. After having received the pulse output from the magnetic transducer 16, the CPU 30 receives the A—D converted value of the photomultiplier output in synchronism with the count quantity of the digital counter 29, which means the position of the slit and stores it therein.

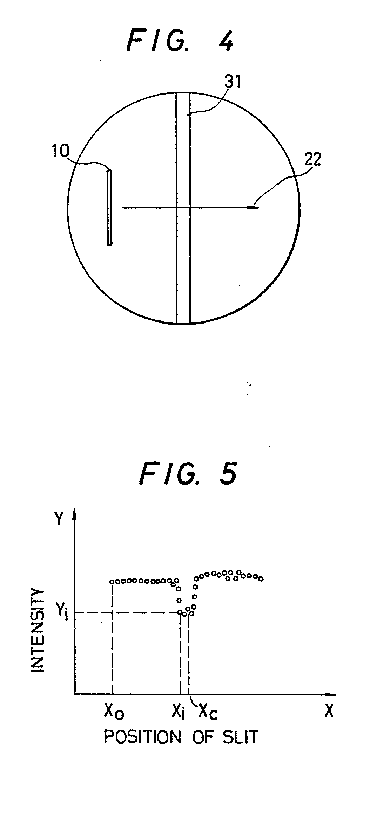

Figure 4 shows an example of the positioning pattern 31 on the wafer projected on the path of movement of the slit 10. Figure 5 shows examples of signals stored in the CPU 30 at this time. The axis of abscissas represents the position X of the slit, while the axis of ordinates represents the A—D converted value Y of the photomultiplier output indicative of the intensity of the light passing through the slit. The digital value of the photomultiplier output begins to be received at a position $X_o$ at which the pulse from the origin sensor is received. When data are received in association with the count quantity of the digital counter 29, which means the position of the slit, the input data at the i-th count value $X_i$ becomes $Y_i$. By processing the signals shown in Figure 5 and evaluating the position $X_c$ of the slit indicative of the center of the positioning pattern 31 on the wafer, the distance of movement of the slit from the origin, thereof is obtained.

The central coordinates of the positioning pattern on the wafer which give rise to this output signal can be evaluated with, for example, the following method. An arbitrary position $X_i$ of the slit is supposed as a tentative center, and data on both sides thereof at positions $X_{i+m}$ to $X_{i-m}$ are superposed to calculate $Z_i$. Here, letting $Y_i$ denote an output signal at the position $X_i$, $Z_i$ is calculated as follows:

$$Z_i = \sum_{j=1}^{m} (Y_{i+j} - Y_{i-j})^2$$

Among the changes of Z thus obtained, a point which gives the minimum value of Z represents the central position of the pattern on the wafer.

In this manner, the positioning pattern on the wafer is magnified and focused through the optical lens, and the focus plane is scanned by the slit having its mechanical origin on the body of the system so as to photoelectrically detect the intensity of the light passing through the slit in accordance with the position of the slit, thereby to measure the position of the wafer relative to the body with high precision, whereupon the wafer and the reticle positioned to the body with the separate detecting optical system are aligned by movement of the reticle.

As set forth above, the position of the positioning pattern on the wafer is detected in terms of the position of the magnified pattern projected by the optical system of simple construction including the reduction lens, whereby the high-precision positional detection has become possible. Experiments have revealed that the detection and reproduction precision of the positioning pattern on the wafer when using this invention is double the precision when using the system shown in Figure 1.

## Claims

1. A reduction projection aligner system wherein a pattern provided on a reticle (2') is formed directly on a wafer (4) by reducing and projecting the pattern onto the wafer through a reduction projection lens (3), comprising means (9) to optically magnify and project and then focus a positioning pattern (31) provided on said wafer (4) onto a focal plane through said lens (3), means (12, 13) to scan the focal plane with a slit (10), and means to relatively move and position the reticle (2') so as to cause the position of its projected image to coincide with the position of said wafer (4), characterized by an origin sensor (16) provided with a mechanical origin on a body of said system for determining a reference position of said slit (10), means (11, 13', 17—20, 23—30) to measure the distance from said reference position to a position where the slit is aligned with the projected positioning pattern to thereby determine the position of said wafer (4) relative to the body of said system, and by said means to relatively move and position the reticle being controlled on the basis of the measurement by said distance measuring means.

2. A reduction projection aligner system according to claim 1, in which the focusing means is constructed of an optical system (9) which includes a single light guide (7).

3. A reduction projection aligner system according to claim 1 or 2, in which the distance measuring means is constructed so as to photoelectrically convert an intensity of light passing through said slit (10) in accordance with the movement of said slit (10), thereby to measure the distance from said reference position of said slit (10) to the position where the slit is aligned with said projected positioning pattern.

## Revendications

1. Dispositif d'alignement avec projection et réduction dans lequel un dessin présent sur un réticule (2') est formé directement sur une pastille (4) par réduction et projection du dessin sur la pastille par l'intermédiaire d'une lentille de protection à réduction (3), et comprenant des moyens (9) servant à réaliser un agrandissement et une projection optiques, puis focaliser un dessin de positionnement (31) présent sur ladite pastille (4), sur un plan focal par l'intermédiaire de ladite lentille (3), des moyens (12, 13) servant á explorer par balayage le plan focal avec une fente (10) et des moyens pour déplacer et positionner d'une manière relative le réticule (2') de manière que la position de son image projetée coïncide avec la position de ladite pastille (4), caractérisé par un capteur (16) de l'origine, muni d'une origine mécanique sur un corps dudit dispositif de manière à déterminer une position de référence de ladite fente (10), par des moyens (11, 13', 17—20, 23—30) servant à mesurer la distance entre ladite position de référence et une position dans laquelle la fente est alignée avec le dessin de positionnement projeté de manière à déterminer ainsi la position de ladite pastille (4) par rapport au corps dudit système, et par lesdits moyens pour déplacer et positionner de façon relative le réticule qui est commandé sur la base de la mesure réalisée par lesdits moyens de mesure de la distance.

2. Dispositif d'alignement avec projection et réduction selon la revendication 1, dans lequel lesdits moyens de focalisation sont constitués par un système optique (9) qui comporte un seul guide de lumière (7).

3. Dispositif d'alignement avec projection et réduction selon la revendication 1 ou 2, dans lequel les moyens de mesure de la distance sont réalisés de manière à transformer par voie photo-électrique une intensitè d'une lumière traversant ladite fente (10) conformément au déplacement de ladite fente (10), de manière à mesurer la distance entre ladite position de référence de ladite fente (10) et la position dans laquelle la fente est alignée avec ledit dessin de positionnement obtenu par projection.

## Patentansprüche

1. Ausrichtsystem für eine verkleinernde Projektionsvorrichtung, bei dem ein auf einer Strichplatte (2') angeordnetes Muster direkt auf einem Wafer (4) abgebildet wird, indem das Muster über einer verkleinernde Projektionslinse (3) reduziert und auf den Wafer projiziert wird, mit einer Vorrichtung (9), um ein auf dem Wafer (4) vorgesehenes Einstellmuster (31) optisch zu vergrößern, zu projizieren und dann auf einer Bildebene scharf einzustellen, mit einer Vorrichtung (12, 13), um die Bildebene mit einem Schlitz (10) abzutasten, und mit einer Vorrichtung für eine Relativbewegung und eine Einstellung der Strichplatte (2') derart, daß die Position ihres projizierten Bildes mit der Position des Wafers (4) zusammenfällt, gekennzeichnet durch einen mit einem mechanischen Nullpunkt auf dem Körper des Systems versehenen Nullpunkt-Sensor (16) zum Feststellen einer Referenzposition des Schlitzes (10), durch eine Vorrichtung (11, 13', 17—20, 23—30), um den Abstand zwischen dieser Referenzposition zu einer Position zu messen, in der der Schlitz auf das projizierte Einstellmuster ausgerichtet ist, um dadurch die Position des Wafers (4) relativ zu dem Körper des Systems zu bestimmen, und dadurch, daß die Vorrichtung zur Relativbewegung und Einstellung der Strichplatte nach Maßgabe der von der Abstands-Meßeinrichtung durchgeführten Messung gesteuert wird.

2. Ausrichtsystem für eine verkleinernde Projektionsvorrichtung nach Anspruch 1, dadurch gekennzeichnet, daß die Abbildungs-Vorrichtung aus einem optischen System (9) besteht, das einen einzelnen Lichtleiter (7) aufweist.

3. Ausrichtsystem für eine verleinernde Projektionsvorrichtung nach Anspruch 1 oder 2, dadurch gekennzeichnet, daß die Abstands-Meßevorrichtung so aufgebaut ist, daß die durch den Schlitz (10) durchtretende Lichtintensität fotoelektrisch in Übereinstimmung zur Bewegung des Schlitzes (10) umgewandelt wird, so daß der Abstand zwischen der Bezugsposition des Schlitzes (10) zu der Position, in der der Schlitz auf das projizierte Einstellmuster ausgerichtet ist, gemessen wird.

# FIG. 1

# FIG. 2

FIG. 3

# FIG. 4

# FIG. 5

POSITION OF SLIT